# EUROPÄISCHE PATENTANMELDUNG

(11) **EP 0 647 961 A1**
(43) Veröffentlichungstag der Anmeldung: **12.04.1995**
(21) Anmeldenummer: 94114602.9
(22) Anmeldetag: 16.09.1994
(51) Int. Cl.: H01J 37/34, C23C 14/56

(54) **Vorrichtung zum Beschichten von langgestreckten biegsamen Erzeugnissen**

(30) Priorität: 28.09.1993 DE 4333825
(71) Anmelder: MAT GmbH Dresden, D-01257 Dresden (DE); Firma SONG GmbH Moskau, Moskau (RU)
(72) Erfinder: Siegert, Lothar Dr.-Ing., D-01239 Dresden (DE); Mucha, Andreas Dr., D-01728 Bannewitz (DE); Werschinin, Nikolaj Fjodorowitsch Dr., Moskowskaja obl. (RU); Powarow, Sergej Nikolajewitsch, Dipl.-Ing., Moskowskaja obl. (RU); Ananjew, Oleg Aleksejewitsch, Dipl.-Ing., Moskowskaja obl. (RU)
(74) Vertreter: Rauschenbach, Marion, Dipl.-Ing.

(57) **Zusammenfassung**

Die Erfindung bezieht sich auf das Gebiet der Metallurgie und betrifft eine Vorrichtung zum Beschichten von langgestreckten biegsamen Erzeugnissen, wie z.B. Drähte, Fasern.

Der Erfindung liegt die Aufgabe zugrunde, eine Vorrichtung anzugeben, bei der vertikal durchzuziehende Erzeugnisse mit gleichmäßiger Schichtdicke beschichtet werden können.

Die Aufgabe wird gelöst durch eine Vorrichtung, enthaltend Elektrodenblöcke, die aus hohlen zylindrischen Langkatoden und aus an den Stirnseiten der Langkatoden angebrachten Zylinderanoden und dazwischen angeordneten Isolierelementen mit einer gemeinsamen Mittelachse bestehen, Anordnungen zur Erzeugung eines Magnetfeldes, Anlagen zum Transportieren, Auf- und Abspulen der langgestreckten biegsamen Erzeugnisse, eine oder mehrere Vakuumkammern, mindestens eine Gaszuführung und eine Stromquelle, wobei bei der Vorrichtung mindestens zwei Elektrodenblöcke vertikal übereinander, die Anordnungen zur Erzeugung eines Magnetfeldes an der hohlen zylindrischen Langkatoden drehbar um und verschiebbar entlang der Langkatodenachse, und elektrisch isolierende Schirme zwischen den Langkatoden und den Zylinderanoden auf den Isolierelementen angeordnet sind.

## Beschreibung

Die Erfindung bezieht sich auf die Gebiete der Metallurgie, der Kabelindustrie und des Gerätebaus und betrifft eine Vorrichtung zum Beschichten von langgestreckten biegsamen Erzeugnissen, wie z.B. Drähte, Fasern, Fäden, mittels Katodenzerstäubung in Gasatmosphäre bei Niederdruck, die z.B. als Spezialdrähte oder als Drahtseile mit verbesserter Qualität zur Anwendung kommen.

Bekannt ist eine Vorrichtung zum Auftragen eines Metallüberzugs auf Metallerzeugnisse mittels der kontinuierlichen Aufbringung des feinpulvrigen Überzugsmaterials auf die Oberfläche des sich horizontal bewegenden Stahlbandes ( US 2812270). Diese Vorrichtung besteht aus zwei Vakuumkammern. Eine Vakuumkammer dient zur Aufbringung des Beschichtungsmaterials und die andere zum Erwärmen des Stahlbandes. Mit Hilfe einer Transporteinrichtung mit Abspul- und Aufspuleinrichtungen wird das Stahlband durch diese Vakuumkammern gezogen, wobei ein Aluminiumüberzug aufgebracht wird. Mindestens im Bereich der Beschichtung bewegt sich das Stahlband horizontal.
Diese Vorrichtung wird aber nur zum Auftragen eines Metallüberzugs auf Stahlbänder verwendet. Bei der Anwendung dieser Vorrichtung zum Beschichten von Draht, Fasern oder Fäden würden große Verluste an Zerstäubungsmaterial wegen der kleinen Querschnitte auftreten. Es gibt auch Beschränkungen in Bezug auf die zur Anwendung kommenden Zerstäubungsmaterialien.

Langgestreckte biegsame Erzeugnisse können bekanntermaßen mittels der Gasphasen- und Vakuumabscheidung beschichtet werden. Unter den Vorrichtungen zum Beschichten mittels Gasphasenmethode ist die Vorrichtung zum Überziehen von Draht mit schwerschmelzbarem Metall (US 4357365) bei kontinuierlichem Durchlauf von Draht in vertikaler Richtung zur Kammerachse bekannt. Sie besteht aus einer Beschichtungskammer mit Eintritts- und Austrittsöffnungen für die Gasmischung, einer Transportanlage mit Abspul- und Aufspulvorrichtungen zur Drahtbeförderung und einer an die Kontakte der Beschichtungskammer angeschlossenen Stromquelle zum Erwärmen des Drahtes.
Eine solche Vorrichtung hat einen begrenzten Anwendungsbereich, da sie zum Beschichten von nicht elektrisch leitenden Fäden oder Fasern nicht geeignet ist. Außerdem hat die Gasphasenmethode zum Beschichten von Draht eine geringere Leistung im Vergleich zur Vakuumabscheidemethode.

Zu den Vorrichtungen zum Beschichten mittels Vakuumabscheidung gehört die Magnetronzerstäubungsvorrichtung (PCT 092/01082), die aus einem Elektrodenblock mit einer hohlen zylindrischen Langkatode und in deren Nähe angeordneten Anoden besteht. Die Innenfläche der Katode ist mit dem Zerstäubungsmaterial bedeckt. Die Vorrichtung enthält fest eingebaute Magnete, die die hohle Langkatode umfassen. Das Aufstäuben wird auf den sich horizontal bewegenden Träger, der sich außerhalb des Innenhohlraumes der Katode befindet, durch eine Öffnung in der Katodenwand durchgeführt.
Solche Vorrichtungen haben den Vorteil, daß sich die Verluste des Katodenmaterials verringern und die Katodenzerstäubung durch die Anwendung von Magneten gleichmäßiger erfolgt.
Der Nachteil dieser Vorrichtung ist aber, daß sie zum Beschichten von flachem Trägermaterial dient, das wegen seiner Maße nicht in der Katode angeordnet werden kann, wodurch sich die Aufstäuberate und die Leistung der Vorrichtung verringert.

Weiterhin sind Magnetron-Vorrichtungen zur Beschichtung von Substraten bekannt (US 4960753). Diese Magnetron-Vorrichtung besteht aus mehreren Einzelvorrichtungen, die übereinander angeordnet sind. In jeder einzelnen Vorrichtung wird das durchlaufende Substrat mit unterschiedlichen Materialien beschichtet. Eine dieser Vorrichtungen besteht aus einer zylindrischen Anode, einer zylindrischen Katode, die mit einem größeren Durchmesser um die Anode herum angeordnet ist, und aus einer Vorrichtung zur Erzeugung eines Magnetfeldes, die ebenfalls mit einem größeren Druchmesser um die Katode herum angeordnet ist. Bei dieser Anordnung ist die Anode prinzipiell bezüglich der Längsachse der Zylinderanordnung innenliegend.
Diese Anordnung ist typisch für ein Magnetron.

Der Nachteil dieser Vorrichtung besteht darin, daß die Anode dem Beschichtungsmaterial ausgesetzt ist und daß durch das so angeordnete Magnetfeld nur ein kreisförmiges Magnetfeld erzeugt werden kann.

Es ist auch eine Elektrodenaufladevorrichtung zur Materialzerstäubung und Abscheidung auf langgestreckte biegsame Erzeugnisse bekannt (z.B. auf Draht), die in der Gasatmosphäre bei einem Druck von kleiner gleich 13,2 Pa horizontal befördert werden (US 3884793). Diese Vorrichtung enthält einen Elektrodenblock, der aus einer hohlen lange Zylinderkatode zwischen zwei koaxial dazu eingebauten Zylinderanoden und aus den zwischen der Katode und den Anoden angeordneten Isolierelementen besteht. Die Innenfläche der Katode ist mit dem Zerstäubungsmaterial bedeckt. Die Vorrichtung enthält ebenfalls Magnete zur Erzeugung von Magnetfeldern in der Katode, die zu der Katodenlängsachse parallel wirken. Die Magnete umschließen den Elektrodenblock und sind als fest eingebaute Magnetspulen auf ferromagnetischen Platten ausgeführt. Der Innenhohlraum der Katode steht in Verbindung mit dem Innenhohlraum der Vakuumkammer, in die man die Transportanlage für die Beförderung der zu beschichtenden Erzeugnisse einschließlich der Abspul- und Aufspuleinrichtungen einbaut. In der Vorrichtung sind Gaszuführungseinrichtungen und eine an den Elektrodenblock angeschlossene Stromquelle vorgesehen.
Nachteilig an dieser Vorrichtung ist aber eine geringe Leistung, weil der Draht horizontal durchgezogen wird und es unmöglich ist, in einem Durchgang durch die Katode die Solldicke der Deckschicht zu sichern. Im Zusammenhang damit, daß die Magnete in der Vorrichtung gegen die Katode unbeweglich sind und die Katode eine große Länge hat, verschleißt das Katodenmaterial ungleichmäßig, da die Entfernung von der Katodenmitte größer als der Abstand zwischen der Katode und jeder Anode ist. Diese Vorrichtung hat außerdem eine kurze Lebensdauer, da eine Schutzvorrichtung gegen die ungewünschte Beschichtung der zwischen der Katode und den Anoden angeordneten Isolierelemente fehlt.

Der Erfindung liegt die Aufgabe zugrunde, eine Vorrichtung zum Beschichten von langgestreckten biegsamen Erzeugnissen mittels der Katodenzerstäubung anzugeben, bei der vertikal durchzuziehende Erzeugnisse mit gleichmäßiger Schichtdicke, mit geringen Aufdampfmaterialverlusten und hohem Durchsatz beschichtet werden können.

Die Aufgabe wird durch die in den Ansprüchen angegebene Erfindung gelöst.

Die erfindungsgemäße Vorrichtung zum Beschichten von langgestreckten biegsamen Erzeugnissen enthält Elektrodenblöcke, die aus hohlen zylindrischen Langkatoden und aus an den Stirnseiten der Langkatoden angebrachten Zylinderanoden und dazwischen angeordneten Isolierelementen mit einer gemeinsamen Mittelachse bestehen, wobei die Langkatoden auf ihrer Mantelinnenoberfläche mit Targetmaterialien beschichtet sind oder vollständig aus dem Targetmaterial bestehen. Dabei sind erfindungsgemäß mindestens zwei Elektrodenblöcke vertikal übereinander angeordnet.

Weiterhin enthält die Vorrichtung Anordnungen zur Erzeugung eines Magnetfeldes, die die hohlen zylindrischen Langkatoden umschließen. Diese Anordnungen sind erfindungsgemäß um die hohlen zylindrischen Langkatoden herum drehbar um und verschiebbar entlang der Langkatodenachse angeordnet.

Ebenfalls enthält die Vorrichtung Anlagen zum Transportieren und Auf- und Abspulen der langgestreckten biegsamen Erzeugnisse.

Im weiteren sind eine oder mehrere Vakuumkammern vorhanden, die mindestens die Langkatoden und die Anlagen zum Transportieren der langgestreckten biegsamen Erzeugnisse aufnehmen, wobei diese in einer gemeinsamen oder in getrennten Vakuumkammern untergebracht sein können.

Außerdem sind noch mindestens eine Gaszuführung und eine Stromquelle vorhanden.

Erfindungsgemäß enthält die Vorrichtung weiterhin elektrisch isolierende Schirme, die zwischen den Langkatoden und den Zylinderanoden auf den Isolierelementen angeordnet sind, wobei der Innendurchmesser der Schirme größer als der Innendurchmesser der Langkatode und kleiner als der Durchmesser der Innenhohlräume der Zylinderanode ist.

Vorteilhafterweise sind beim Einsatz von mehr als zwei Elektrodenblöcken, diese in einer vertikalen Reihe angeordnet.

Weiterhin sind vorteilhafterweise beim Einsatz von mehr als zwei Elektrodenblöcken, jeweils mindestens zwei vertikal übereinander angeordnete Elektrodenblöcke parallel nebeneinander angeordnet.

Ebenfalls vorteilhafterweise befindet sich die Gaszuführung zwischen den Anlagen zum Auf- und Abspulen der langgestreckten biegsamen Erzeugnisse, wobei die Gasströmungsrichtung entgegen der Bewegungsrichtung der langgestreckten biegsamen Erzeugnisse gerichtet ist.

Und ebenfalls vorteilhaft ist es, daß die Schirme zerlegbar sind.

Der vertikale Aufbau der Vorrichtung ermöglicht es, daß die langgestreckten biegsamen Erzeugnisse mit gleichmäßiger Schichtdicke, mit geringen Targetmaterialverlusten und mit einem hohen Durchsatz beschichtet werden können.
Dabei ist es notwendig, die Erzeugnisse genau senkrecht oder in einem die Katodenachse entlang und zu ihr symmetrisch liegenden Bereich mit einem Radius , der 0,2 vom Katodenradius beträgt, zu transportieren, da davon die Gleichmäßigkeit des Beschichtens von Erzeugnissen abhängt. Falls die Abweichung von der Senkrechten bei der Bewegung von Erzeugnissen den angegebenen Wert überschreitet, entstehen Probleme beim Transportieren der Erzeugnisse. Wegen des Durchhangs fällt die Aufdampfgleichmäßigkeit ab und es entstehen Zusatzbelastungen in der Transportanlage, weil Zusatzkräfte zum Spannen der Erzeugnisse angelegt werden müssen.

Durch den Einbau von weiteren Elektrodenblöcken, die vertikal zu den Vakuumkammern eingebaut und gegen diese elektrisch isoliert sind, wird erreicht, daß die Abscheidung des Targetmateials auf die Erzeugnisse mit hoher Geschwindigkeit erfolgt, aber gleichzeitig die Isolierung der Elektrodenblöcke gegen die Vakuumkammer gesichert ist, wodurch eine zuverlässige Funktion (Fehlen von Durchschlägen) durch Abschirmung vor dem Beschlagen mit Targetmaterial erreicht wird. Deswegen ist es günstiger, mehrere Elektrodenblöcke zu verwenden und Vakuumentladungen dazwischen aufrechtzuerhalten.
Die in der Vorrichtung vorhandene Anordnung zur Erzeugung des Magnetfeldes besteht aus die Katode umfassenden Platten, aus einem Material mit hoher magnetischer Durchlässigkeit, mit dazwischen angeordneten Dauermagneten, die eine sich abwechselnde Polarität haben. Für die Überführung der Entladung in den Magnetronbetriebszustand ist es notwendig, an der Oberfläche der Langkatode ein Bogenmagnetfeld zu erzeugen. Dazu dienen die Platten, die mit Hilfe der Dauermagneten magnetisiert werden. Bei Dauerbetrieb der Vorrichtung ist es nötig, die Bewegung des Bogenmagnetfeldes der Langkatodenoberfläche gegenüber zu sichern; infolge der Ungleichmäßigkeit der Magnetisierung der Platten mit Hilfe von Dauermagneten bewegt man die Anordnung zur Erzeugung des Magnetfeldes entlang der Längsachse der Langkatode und um diese Achse herum, um die gleichmäßige Beschichtung von Erzeugnissen und die gleichmäßige Zerstäubung des Targetmaterials zu erreichen.

Die Elektrodenblöcke in der Vorrichtung können in einer vertikalen Linie, einer nach dem anderen, angeordnet werden. Diese Anordnung hat besondere Vorteile, wenn damit dünne Erzeugnisse und Erzeugnisse mit geringer mechanischer Festigkeit bedampft werden sollen. Damit wird ein abrißfreier Vorschub beim Aufdampfen die in der Transportanlage gesichert.

Die erfindungsgemäße Vorrichtung enthält weiterhin elektrisch isolierte Schirme mit zylindrischen Innenhohlräumen, die in den Elektrodenblock zwischen der Langkatode und den Zylinderanoden eingebaut sind. Das ist erforderlich, um eine stabile Entladung und die Reproduzierbarkeit der Beschichtung zu sichern, da von der Geometrie der Innenflächen der Langkatode, der Zylinderanoden und der elektrisch isolierten Schirme die Parameter der Entladung abhängen, die für das Aufstäuben auf die Erzeugnisse entscheidend sind. Dabei ist der Innendurchmesser der elektrisch isolierten Schirme größer als der Innendurchmesser der Langkatode und kleiner als der Innendurchmesser der Zylinderanoden. Das ist erforderlich, um die Isolierelemente gegenüber Beschlagen durch das Katodenmaterial zu sichern, da die Lebensdauer der Vorrichtung in hohem Maße auch von diesem unerwünschten Beschlagen der Isolierelemente abhängt. Zu diesem Zweck sind Langkatode, Zylinderanoden und elektrisch isolierte Schirme zerlegbar ausgeführt und die Innendurchmesser sind kleiner als der Durchmesser der Isolierelemente.

Die Anordnung der Gaszuführungseinrichtung zwischen den Anlagen zum Auf- und Abspulen der langgestreckten biegsamen Erzeugnisse sichert die Erhöhung der Deckschichtqualität und gleichzeitig den Schutz der Anlage zum Transportieren und Auf- und Abspulen der langgestreckten biegsamen Erzeugnisse gegen das Beschlagen durch die Wahl der Führung des Gasgemisches von der Gaszuführungseinrichtung durch die Innenhohlräume der Langkatoden in die Vakuumkammern. Die Deckschichtqualität erhöht sich mit der Verminderung der Menge an Fremdstoffen, die damit während des Abdampfens von den Anlagen zum Transportieren, Auf- und Abspulen der langgestreckten biegsamen Erzeugnisse durch den Gegenstrom nicht in die Innenhohlräume der Langkatoden eindringen können.

Zwecks der Leistungserhöhung der Vorrichtung werden jeweils zwei vertikal übereinander angeordnete Elektrodenblöcke parallel zueinander angeordnet.
Die Vorrichtung zum Beschichten von langgestreckten biegsamen Erzeugnissen funktioniert folgendermaßen.

Die zu beschichtenden langgestreckten biegsamen Erzeugnisse werden auf die Anlage zum Transportieren und Auf- und Abspulen der langgestreckten biegsamen Erzeugnisse gelegt. Danach werden die Vakuumkammern evakuiert. Anschließend wird die Gaszuführung erwärmt. Nach Erreichen der gewünschten Temperatur wird die Gaszuführung geöffnet und in den Innenhohlraum der Langkatode tritt die Gasmischung ein. Die gleichmäßige Zufuhr wird durch die Temperaturkontrolle der Gaszuführung z.B. mit Hilfe eines Thermowiderstandes gesichert. Mit Hilfe der Stromquelle wird ein Potential auf der Oberfläche der Langkatode erzeugt und die elektrische Entladung in der Langkatode wird im vorgegebenen Kapazitätsbereich (z.B. 1000 W) aufrechterhalten.

Um den Targetwerkstoff voll auszunutzen und die Betriebszeit der Vorrichtung zu verlängern, sind die Zylinderanoden von der Langkatode durch die elektrisch isolierten Schirme abgetrennt. Die elektrischen Isolierelemente dienen auch als Vakuumdichtung.

Zur Leistungserhöhung bewegt sich die Anordnung zur Erzeugung des Magnetfeldes mit den Platten und dem Dauermagneten während des Beschichtens gegenüber der Langkatode. Als Ergebnis der Vakuumentladung in der Langkatode, die zur Leistungserhöhung auf den Magnetronbetriebszustand umgestellt ist, bildet sich auf den zu beschichtenden Erzeugnissen eine geschlossene Deckschicht aus dem Targetmaterial und zwar mit hoher Homogenität bezüglich Länge und Umfang des Erzeugnisses.

Zur Sicherung der stabilen Funktion der Langkatode im Magnetronbetriebszustand wird der Druck der Gasmischung im Bereich 10 - 0,01 mm Hg aufrechterhalten, dabei erhöht sich die Geschwindigkeit der Gasphasenerzeugung vom Werkstoff der Langkatode und die Konstanz der Beschichtungsparameter der Vorrichtung.

Während des Beschichtungsvorganges werden die Erzeugnisse in vertikaler Richtung mit der Geschwindigkeit von 0,01 - 10 m/min die Katodenachse entlang transportiert. Dieser Geschwindigkeitsbereich ist aus folgenden Gründen gewählt worden:
Bei einer Geschwindigkeit unter 0,1 m/min tritt eine bedeutende Erwärmung der Erzeugnisse auf, was häufig Brüche zur Folge hat; außerdem ist die Vorrichtung bei solchen Geschwindigkeiten wenig effektiv. Beim Transport über 20 m/min ist es kompliziert, die Eigenschwingungen der Erzeugnisse zu beherrschen und annehmbare minimale Schichtdicken zu erreichen.

Eine Verbesserung der Deckschichtqualität und die Erhöhung der Beschichtungsrate können in dieser Vorrichtung mittels der Zuführung von einer Gasmischung in den Hohlraum der Langkatode erreicht werden. Z.B. steigt bei der Zuführung einer Argon-Xenon-Mischung die Beschichtungsrate an. Die Zugabe von Ammoniak zu der Gasmischung hat sowohl die Erhöhung der Beschichtungsrate als auch die Verbesserung der Schichtqualität zur Folge. Die Zugabe von Helium verbessert die Qualität infolge Porositätsverminderung.

Das Arbeitsgas wird nach dem Austritt aus der Vakuumkammer gesammelt und erneut dem Innenhohlraum der Langkatode zugeführt.

Bei der Funktion der Vorrichtung nach dem Entladungsprinzip mit einer Langkatode hat die Reinheit des Targetwerkstoffs wegen des Materialübertrags auf die Erzeugnisse eine große Bedeutung. Da beim Materialübertrag auch eine Gasabscheidung stattfindet, ist die Reinheit des zu verwendenden Gases sehr wichtig. Selbst geringe Beimischungen von aktiven Gasen, z.B. von Sauerstoff und Stickstoff, haben beim mehrfachen Targetmaterialübertrag einen großen Einfluß auf die chemische Zusammensetzung der hergestellten Deckschichten. Andererseits wird das Gas nach dem Durchgang des Hohlraumes der Langkatode von reaktiven Beimischungen infolge ihrer Adsorbtion mit dem Targetwerkstoff, der bei der Beschichtung übertragen wird, gereinigt. Es ist zweckmäßig, solch ein gereinigtes Gas wieder für die Arbeit zu verwenden. Außerdem ist die Einsparung von so kostspieligen Gasen, wie Helium, Krypton und Xenon ein nicht unbedeutender wirtschaftlicher Faktor.

Die Gasmischung kann inerte und reaktive Gase enthalten. Das ermöglicht, unterschiedliche Typen von isolierenden, verschleißfesten oder dekorativen Deckschichten herzustellen. Bei der Zuführung von Sauerstoff ist es z.B. möglich, isolierende oder verschleißfeste Deckschichten auf Grundlage von Oxiden herzustellen, weil bei der Verwendung einer Aluminiumkatode die hergestellten Deckschichten gute Isoliereigenschaften und eine gute Verschleißfestigkeit haben; bei der Verwendung von Stickstoff als reaktives Gas kann man dekorative Deckschichten aus Titannitrid herstellen, usw.

Bei der Beschichtung von elektrisch leitfähigen Teilen sind neue Behandlungsprinzipien möglich. Um eine Wärmebehandlung durchzuführen, reicht es aus, den Teilen ein positives Potential gegenüber dem Plasma anzulegen, daraufhin werden sie sich infolge der Bombardierung durch Elektronen erwärmen. Man kann den Erwärmungsgrad mittels der Potentialwertänderung regeln. Wird ein negatives Potential an das Erzeugnis angelegt, wird es dem Ionenbombardement ausgesetzt, was auch zu seiner Erwärmung führt. Da aber die Elektronenbewegung im Plasma dreimal so hoch wie die Ionenbeweglichkeit ist, ergibt sich eine weniger effektive Erwärmung der Teile durch Ionen als durch Elektronen. Andererseits läßt sich das Ionenbombardement zur Reinigung der Teile und das Beschichten gleichzeitig mit der Bombardierung durch Ionen durchführen, wodurch das Adhäsionsvermögen der Deckschichten und ihre Qualität verbessert werden.

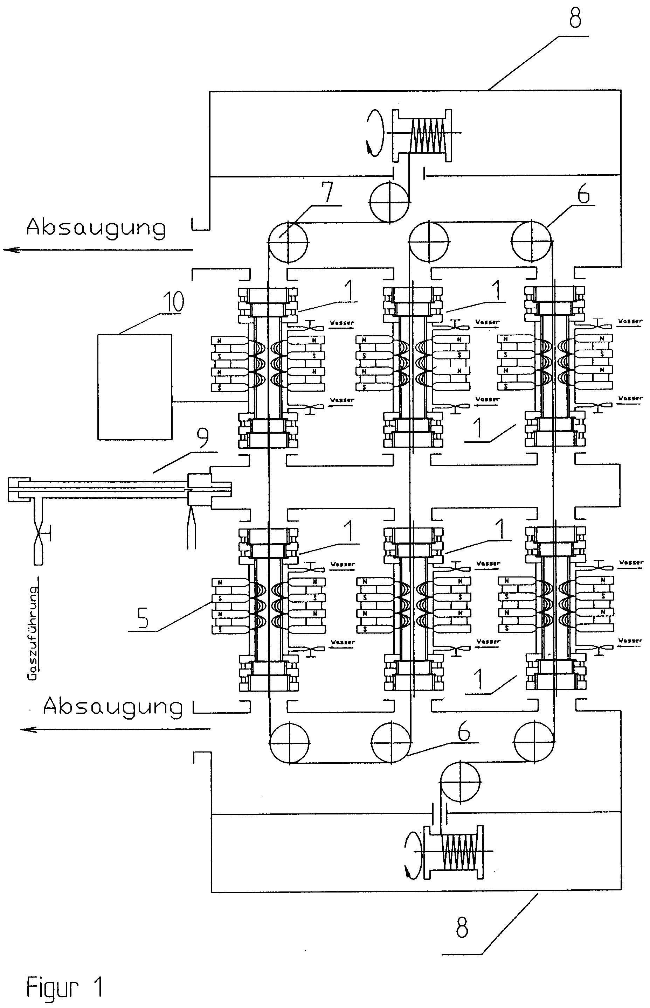

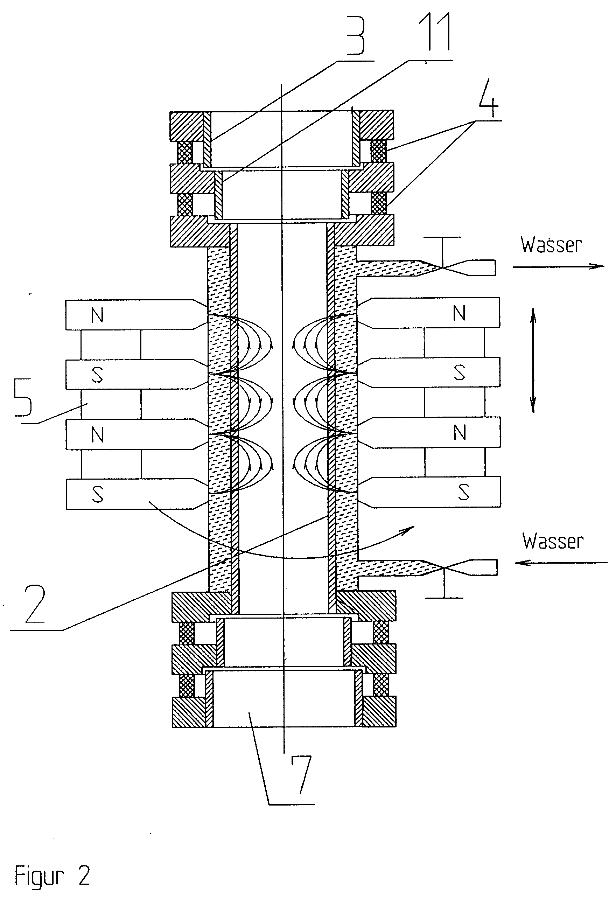

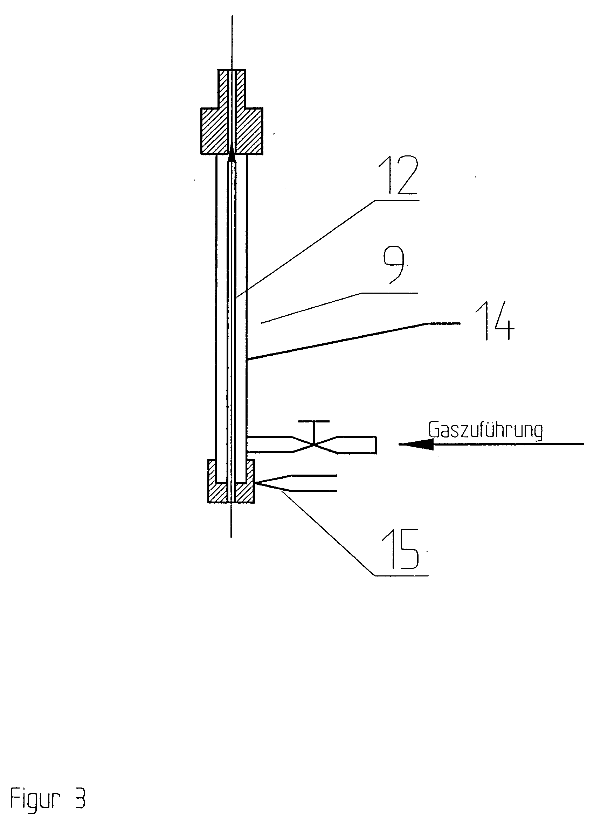

Im folgenden ist die Vorrichtung anhand eines Ausführungsbeispiels näher erläutert. Die zugehörigen Zeichnungen zeigen in schematischer Darstellung mit Figur 1 den schematischen Aufbau der erfindungsgemäßen Vorrichtung zum Beschichten von langgestreckten biegsamen Erzeugnissen, in Figur 2 einen Elektrodenblock und in Figur 3 eine Gaszuführung.

Die Vorrichtung zum Beschichten von langgestreckten biegsamen Erzeugnissen 7 besteht aus sechs Elektrodenblöcken 1. Dabei sind jeweils zwei vertikal übereinander angeordnete Elektrodenblöcke 1 parallel zueinander angeordnet. Die Elektrodenblöcke 1 bestehen jeweils aus einer hohlen Langkatode 2, zwei an den Stirnseiten der Langkatoden 2 angeordneten Zylinderanoden 3 und Isolierelementen 4, die zwischen der Langkatode 2 und den Zylinderanoden 3 angeordnet sind. Weiterhin sind elektrisch isolierte Schirme 11 mit zylindrischem Innenhohlraum auf den Isolierelementen 4 zwischen der Langkatode 2 und den Zylinderanoden 3 angeordnet. Die Langkatode 2, die Zylinderanoden 3, die Isolierelemente 4 und die Schirme 11 sind koaxial zueinander angeordnet.

Die Vorrichtung enthält auch eine Anlage zum Transportieren und zum Auf- und Abspulen 6 von langgestreckten biegsamen Erzeugnissen 7. Weiterhin sind Vakuumkammern 8 vorhanden, die senkrecht zu den Elektrodenblöcken 1 angeordnet und elektrisch isoliert davon sind und zur Aufnahme von Elementen der Anlage zum Transportieren, Auf- und Abspulen 6 von langgestreckten biegsamen Erzeugnissen 7 dienen. Die Innenhohlräume der Elektrodenblöcke 1 und der Vakuumkammern 8 sind miteinander verbunden.

Die Gaszuführung 9 in die Vorrichtung besteht aus dem Gehäuse 14 mit einem Thermowiderstand 15 und aus dem Nadelventil 12 und ist zwischen den Abspul- und Aufspulelementen der Anlage zum Transportieren, Auf- und Abspulen 6 von langgestreckten biegsamen Erzeugnissen 7 angeordnet. Das Gehäuse 14 ist aus einem Werkstoff mit großem Ausdehnungskoeffizienten und das Nadelventil 12 aus einem Werkstoff mit kleinem Ausdehnungskoeffizienten hergestellt, wodurch sich das Nadelventil 12 im Gehäuse 14 in Abhängigkeit von der Temperatur bewegen läßt. Der Thermowiderstand 15 dient zur Temperaturkontrolle des Gehäuses 14 und gleichzeitig als Geber für die Rückkopplung zu einer Steuereinrichtung.

Die Vorrichtung enthält die Anordnung zur Erzeugung des Magnetfeldes 5, die aus drei oder mehr Platten aus einem Werkstoff mit hoher magnetischer Durchlässigkeit mit dazwischen eingebauten Dauermagneten mit sich abwechselnder Polarität besteht, die koaxial zur Achse der Langkatode 2 angeordnet sind. Die Platten mit den Dauermagneten bewegen sich entlang der Längsachse der Langkatode 2 und um diese Achse herum.

Die Langkatode 2, die Zylinderanoden 3 und die Schirme 11 stellen zerlegbare Zylinder dar, außerdem soll der Innendurchmesser des Katodenzylinders zwischen 0,01 - 0,5 m liegen, wobei das Verhältnis zwischen seiner Länge und seinem Innendurchmesser >2 sein soll. Die Langkatode 2 ist zwischen den Zylinderanoden 3 angeordnet.

Die Mantellinienlänge der Anodenzylinder 3 und der Schirme 11 wird mit Rücksicht auf die Notwendigkeit gewählt, die Abschirmung der Isolierelemente 4 gegen das Zerstäubungsmaterial der Langkatode 2 zu sichern.

Die Stromquelle 10 ist zur Potentialerzeugung auf der Oberfläche der Langkatode 2 an den Elektrodenblock 1 anzuschließen.

## Patentansprüche

1. Vorrichtung zum Beschichten von langgestreckten biegsamen Erzeugnissen, enthaltend Elektrodenblöcke, die aus hohlen zylindrischen Langkatoden und aus an den Stirnseiten der Langkatoden angebrachten Zylinderanoden und dazwischen angeordneten Isolierelementen mit einer gemeinsamen Mittelachse bestehen, wobei die Langkatoden auf ihrer Mantelinnenoberfläche mit Aufdampfmaterialien beschichtet sind oder vollständig aus dem Aufdampfmaterial bestehen, Anordnungen zur Erzeugung eines Magnetfeldes, die die hohlen zylindrischen Langkatoden umschließen, Anlagen zum Transportieren, Auf- und Abspulen der langgestreckten biegsamen Erzeugnisse, eine oder mehrere Vakuumkammern, die mindestens die Langkatoden und die Anlagen zum Transportieren der langgestreckten biegsamen Erzeugnisse aufnehmen, wobei diese in einer gemeinsamen oder in getrennten Vakuumkammern untergebracht sein können, mindestens eine Gaszuführung und eine Stromquelle dadurch gekennzeichnet, daß mindestens zwei Elektrodenblöcke (1) vertikal übereinander angeordnet sind, daß die Anordnungen zur Erzeugung eines Magnetfeldes (5) an der hohlen zylindrischen Langkatoden (2) drehbar um und verschiebbar entlang der Langkatodenachse angeordnet sind, und daß elektrisch isolierende Schirme (11) zwischen den Langkatoden (2) und den Zylinderanoden (3) auf den Isolierelementen (4) angeordnet sind, wobei der Innendurchmesser der Schirme (11) größer als der Innendurchmesser der Langkatode (2) und kleiner als der Durchmesser der Innenhohlräume der Zylinderanode (3) ist.

2. Vorrichtung nach Anspruch 1, dadurch gekennzeichnet, daß beim Einsatz von mehr als zwei Elektrodenblöcken (1), diese in einer vertikalen Reihe angeordnet sind.

3. Vorrichtung nach Anspruch 1, dadurch gekennzeichnet, daß beim Einsatz von mehr als zwei Elektrodenblöcken (1), jeweils mindestens zwei vertikal übereinander angeordnete Elektrodenblöcke (1) parallel nebeneinander angeordnet sind.

4. Vorrichtung nach Anspruch 1, dadurch gekennzeichnet, daß die Gaszuführung (9) zwischen den Anlagen zum Auf- und Abspulen (6) der langgestreckten biegsamen Erzeugnisse (7), wobei die Gasströmungsrichtung entgegen der Bewegungsrichtung der langgestreckten biegsamen Erzeugnisse (7) gerichtet ist.

5. Vorrichtung nach Anspruch 1, dadurch gekennzeichnet, daß die Schirme (11) zerlegbar sind.
